# EUROPÄISCHE PATENTANMELDUNG

(11) **EP 1 379 114 A1**
(43) Veröffentlichungstag der Anmeldung: **07.01.2004**
(21) Anmeldenummer: 03010975.5
(22) Anmeldetag: 16.05.2003
(51) Int. Cl.: H05K 5/06, B05C 1/02, B05C 1/08, E01C 23/09

(54) **Verfahren zum Aufbringen einer Dichtungsmasse auf eine Kontur eines Gehäuses und Vorrichtung**

(30) Priorität: 02.07.2002 DE 10229511
(71) Anmelder: Valeo Schalter und Sensoren GmbH, 74321 Bietigheim-Bissingen (DE)
(72) Erfinder: Biehlmann, Bernd, 71638 Ludwigsburg (DE); Walz, Dirk, 72654 Neckartenzlingen (DE); Künzler, Frank, 76703 Kraichtal (DE); Papziner, Uwe, 71739 Oberriexingen (DE)
(74) Vertreter: Dreiss, Fuhlendorf, Steimle & Becker

(57) **Zusammenfassung**

Verfahren und Vorrichtung zum Aufbringen einer Dichtungsmasse (1) auf eine Kontur (4) eines abzudichtenden Gehäuseteils, insbesondere zur Abdichtung einer Haube (5) einer elektronischen Hochfrequenzschaltung (6), wobei es folgende Schritte aufweist:
a). Benetzen einer Fläche (A, B) eines Werkzeuges (3) mit einer Dichtungsmasse (1); und
b). Zusammenbringen der benetzten Fläche (A, B) mit der Kontur (4) des Gehäuseteils (5) in einem einzigen Arbeitsgang unabhängig von der Form der Kontur (4).

## Beschreibung

Die Erfindung betrifft ein Verfahren und eine Vorrichtung zum Aufbringen einer Dichtungsmasse auf eine Kontur eines Gehäuses, insbesondere einer Schutzhaube einer elektronischen Schaltung. Elektronische Schaltungen werden mit einer Haube zum Schutz gegen äußere Einflüsse versehen, welche an einer Platine oder Leiterplatte der elektronischen Schaltung dicht befestigt wird, so dass die Elektronik der Schaltung vor Feuchtigkeit und/oder vor anderen äußeren Einflüssen geschützt ist. Die vorliegende Erfindung betrifft jedoch ebenso allgemein das Aufbringen einer Dichtungsmasse auf eine Kontur eines Gehäuses, welches mit einem plattenartigen Basisteil verbunden wird zum Bilden eines abgeschlossenen, dichten Gehäuses. Unter Kontur eines Gehäuses wird vorliegend der Rand eines haubenartigen Gehäuses verstanden, welcher in einer Ebene liegt, jedoch in seinem Verlauf beliebig ausgebildet sein kann, das heißt konturiert sein kann. Beispielsweise kann ein Rand eines haubenartigen Gehäuses eine runde, eine ovale, eine rechteckige, eine abgeschrägte Form oder dergleichen aufweisen.

Zum industriellen Aufbringen einer Dichtungsmasse auf eine derartige Kontur ist es bekannt, eine sogenannte Dichtraupe aus einem Dichtmaterial, insbesondere eine Kunststoffmasse, mittels eines Industrieroboters oder einer Spezialmaschine durch Abfahren der Kontur aufzubringen. Hierfür ist es erforderlich, bei unterschiedlichen Konturen den Roboter oder die Maschine entsprechend mit der jeweiligen Kontur zu programmieren. Dies ist nicht nur zeitaufwändig, sondern auch kostenintensiv, da in der industriellen Fertigung von Bauteilen das Aufbringen der Dichtmasse auf die Kontur des Gehäuses somit äußerst aufwändig ist.

Die vorliegende Erfindung hat demgegenüber zur Aufgabe, ein Verfahren und eine Vorrichtung zum Aufbringen einer Dichtungsmasse auf eine Kontur eines abzudichtenden Gehäuseteils bereitzustellen, welches unter geringerem Zeitaufwand und reduzierten Kosten ein Aufbringen von Dichtungsmasse auch an verschieden konturierten Gehäusen ermöglicht.

Diese Aufgabe wird erfindungsgemäß dadurch gelöst, dass eine Fläche eines Werkzeuges mit der Dichtungsmasse benetzt wird und die benetzte Fläche mit der Kontur des Gehäuseteils in einem einzigen Arbeitsgang unabhängig von der jeweiligen, spezifischen Form der Kontur zusammengebracht wird. Es ist somit nicht erforderlich, abhängig von der Kontur des Gehäuseteils die Maschine auf diese Kontur spezifisch einzustellen, sondern es wird in einem einzigen Arbeitsgang die gesamte Kontur durch Zusammenbringen mit der benetzten Fläche des Werkzeuges mit Dichtungsmasse versehen. Hierdurch wird das Aufbringen von Dichtungsmasse, insbesondere für die industrielle Herstellung von dichten elektronischen Schaltungen, wie zum Beispiel Hochfrequenzschaltungen, Radar-Sensoren oder dergleichen vereinfacht.

Nach einer vorteilhaften Ausgestaltung der Erfindung wird eine ebene Fläche eines stempelartigen Werkzeuges mit Dichtungsmasse benetzt. Durch Zusammenbringen dieser ebenen Fläche, auf welcher die Dichtungsmasse aufgebracht worden ist, kann dann in einem einzigen Arbeitsgang die ebene Kontur des Gehäuseteils mit der Dichtungsmasse versehen werden. Ähnlich einem Stempel, welcher unabhängig von den Schriftzeichen oder den Motiven der Stempelkontur in einem einzigen Schritt in einem Stempelkissen mit Farbstoff benetzt wird, wird bei dem erfindungsgemäßen Verfahren vorteilhafterweise durch einen einzigen Arbeitsgang die gesamte Kontur unabhängig von ihrem spezifischen Verlauf bzw. ihrer Form mit dem Werkzeug benetzt. Das Verfahren ist somit zeitsparend.

Nach einer weiteren, alternativen Ausgestaltung der Erfindung wird eine zylinderförmige Fläche eines walzenartigen Werkzeuges mit Dichtungsmasse benetzt. Das Übertragen der Dichtungsmasse von dem Werkzeug auf die Kontur des Gehäuseteils erfolgt dann durch relatives Abrollen des Werkzeuges über die Kontur des Gehäuseteils, im Unterschied zum stoßartigen Zusammenbringen der Kontur mit dem Werkzeug (Stempel) nach dem zuvorigen Ausführungsbeispiel. Bei der zylinderförmigen Fläche eines walzenförmigen Werkzeuges, ähnlich zu einer Malerwalze zum Streichen von Gebäudewänden, ist vorteilhaft, dass das Werkzeug einen relativ geringen Raumbedarf aufweist und lediglich eine translatorische Bewegung zwischen Werkzeug und Kontur erforderlich ist beim Applizieren der Dichtungsmasse.

Nach einer weiteren vorteilhaften Ausgestaltung der Erfindung wird die Kontur des Gehäuseteils im Verhältnis zum Werkzeug beim Aufbringen bzw. Applizieren der Dichtungsmasse bewegt. Das Werkzeug kann hierbei stationär ausgebildet sein und erfordert keine aufwändigen Betätigungsmechanismen in mehreren Richtungen zum Benetzen und zum Zusammenbringen mit dem Gehäuseteil.

Nach einer weiteren, alternativen Ausführungsform der Erfindung wird das Werkzeug im Verhältnis zur Kontur beim Aufbringen der Dichtungsmasse bewegt. Hierbei ist das Werkstück, das heißt das die Kontur aufweisende Gehäuseteil, stationär beim Aufbringen der Dichtungsmasse, und das Werkzeug mit der mit Dichtungsmasse benetzten Fläche wird auf die Kontur zu bewegt und von ihr wieder entfernt.

Nach einer weiteren vorteilhaften Ausgestaltung der Erfindung wird die Kontur einer Abschirmung oder einer Schutzhaube gegen elektromagnetische Störungen mit einer elektrisch leitfähigen Dichtmasse abgedichtet zur Herstellung einer elektronischen Hochfrequenzschaltung. Das Verfahren ist hierfür besonders vorteilhaft, da eine große Vielzahl von elektronischen Hochfrequenzschaltungen mit unterschiedlichsten Konturen und Formen der Gehäuseteile herstellbar ist bei reduzierten Kosten und in kürzerer Zeit als bisher. Hochfrequenzschaltungen sind zum Beispiel in Mobiltelefonen, bei Radar-Sensoren oder jedweden anderen elektronischen Schaltungsteilen mit einer hohen Frequenz vorhanden, wobei immer eine Abschirmung von einer elektromagnetischen Strahlung, welche Störeinflüsse verursachen kann, vermieden werden muss. Unter hoher Frequenz wird vorliegend eine Frequenz von über 1 MHz verstanden.

Nach einer weiteren vorteilhaften Ausgestaltung der Erfindung wird ein Werkzeug mit einer Fläche verwendet, welche eine Flächengröße aufweist, die größer ist als die Umhüllende einer maximalen Größe einer zu benetzenden Kontur. Die zu benetzende Kontur von Gehäuseteilen ist somit immer durch ein und dasselbe Werkzeug mit einer Dichtungsmasse versehbar, ohne dass ein Werkzeugwechsel erforderlich wäre.

Die genannte Aufgabe wird auch durch eine Vorrichtung zur Durchführung des erfindungsgemäßen Verfahrens gelöst.

Weitere Merkmale, vorteilhafte Ausgestaltungen und Einzelheiten der Erfindung sind der nachfolgenden Beschreibung zu entnehmen, in welcher die Erfindung anhand der in der Zeichnung dargestellten Ausführungsbeispiele näher beschrieben und erläutert ist.

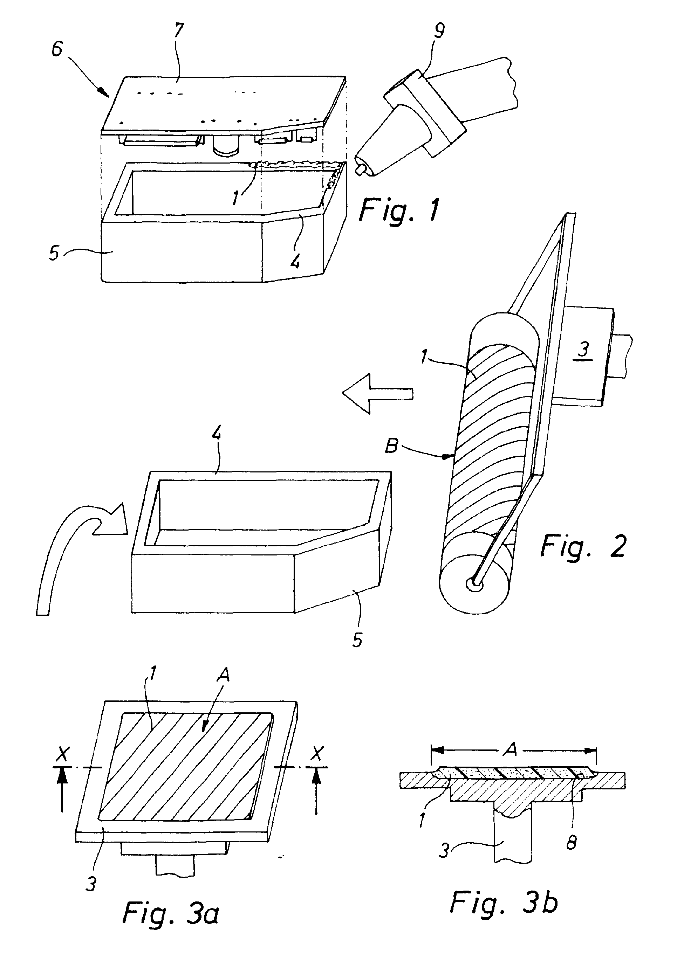

In Figur 1 ist schematisch dargestellt, wie gemäß dem Stand der Technik die Dichtungsmasse 1 in Form einer Dichtraupe auf die Kontur 4 des Gehäuseteils bzw. der Schutzhaube 5 einer elektronischen Hochfrequenzschaltung 6 aufgebracht wird. Die Dichtungsmasse 1 wird dabei mit Hilfe eines Roboters 9, welcher die Kontur 4 der Haube 5 unter Ausgeben der Dichtungsmasse 1 abfährt, auf den Rand, das heißt die Kontur 4 der Haube 5, aufgebracht. Somit muß je nach unterschiedlicher Kontur, Form und Größe der Haube 5 der Roboter 9 entsprechend programmiert werden, zum Abfahren der jeweiligen Kontur für ein industrielles Aufbringen der Dichtungsmasse 1. Dieses Verfahren ist relativ zeitaufwändig und kostenintensiv.

In den Figuren 2, 3a und 3b sind zwei Ausführungsbeispiele der Erfindung schematisch dargestellt. In dem ersten Ausführungsbeispiel gemäß der Figur 2 ist ein walzenartiges Werkzeug 3 vorgesehen, welches eine zylinderförmige Fläche B aufweist, die mit Dichtungsmasse 1 benetzt ist. Erfindungsgemäß wird das Werkzeug 3 in einem einzigen Arbeitsgang in der in Figur 2 mit dem Pfeil gekennzeichneten Richtung über die Kontur 4 der Haube 5 so geführt, dass die gesamte Kontur 4 mit Dichtungsmasse 1 versehen wird. Somit kann unabhängig von der Form der Kontur 4 mit ein und dem gleichen Werkzeug 3 die Dichtungsmasse 1 aufgebracht werden. Das Verfahren gemäß der Erfindung ist schnell und die Kosten in der Herstellung von Abdichtungen für elektronische Schaltungen werden reduziert, was zu insgesamt geringeren Herstellungskosten führt. Die Dichtungsmasse 1 kann insbesondere eine Kunststoffmasse sein, die elektrisch leitfähig ist. Dies ist bei Hochfrequenzschaltungen, wie beispielsweise Radar-Sensoren oder elektronischen Schaltungen von Mobiltelefonen, erforderlich, um einen Schutz vor elektromagnetischen Störungen der Schaltung vorzusehen.

In den Figuren 3a und 3b ist schematisch eine zweite Ausführungsform der Erfindung dargestellt. In Figur 3a ist in einer schematischen Schrägdraufsicht ein stempelartiges Werkzeug 3 mit einer ebenen Fläche A wiedergegeben, die mit einer Dichtungsmasse 1 benetzt ist. Die Fläche A ist in ihrem Umfang so bemessen, dass sie größer als die Außenabmessungen der zu benetzenden Konturen 4 der Hauben 5 ist. Durch einfaches Zusammenbringen der mit Dichtungsmasse 1 benetzten Fläche A des stempelartigen Werkzeuges 3 und der Kontur 4 - wie es in Figur 3a mit dem Pfeil angedeutet ist - kann die Dichtungsmasse 1 auf die gesamte Kontur 4 in einem einzigen Arbeitsschritt aufgebracht werden. Das Benetzen der Kontur 4 mit Dichtungsmasse 1 durch das Werkzeug 3 kann dabei ebenso wie in dem zuvorigen Ausführungsbeispiel der Figur 2 entweder durch Bewegen des Werkzeuges 3 oder alternativ durch Bewegen der Haube 5 mit der Kontur 4 auf die jeweilige Fläche A, B hin erfolgen. In Figur 3b ist das Werkzeug 3 der Figur 3a in einer Schnittansicht dargestellt. Die Fläche A ist im Verhältnis zur Oberkante bzw. der "Stempelfläche" des Werkzeuges 3 vertieft, so dass eine wannenartige Vertiefung 8 gebildet ist. Die Dichtungsmasse 1 wird in die Vertiefung 8, zum Beispiel durch Benetzen, aufgebracht, bevor die Fläche A des Werkzeuges 3 mit der Kontur 4 der Haube 5 zusammengebracht wird. Selbstverständlich kann die Fläche A auch ohne Vertiefung 8 auf dem Werkzeug 3 vorgesehen sein.

Sämtliche in der Beschreibung, den nachfolgenden Ansprüchen und der Zeichnung dargestellten Merkmale können sowohl einzeln als auch in beliebiger Kombination miteinander erfindungswesentlich sein.

## Patentansprüche

1. Verfahren zum Aufbringen einer Dichtungsmasse (1) auf eine Kontur (4) eines abzudichtenden Gehäuseteils, insbesondere zur Abdichtung einer Haube (5) einer elektronischen Hochfrequenzschaltung (6), **gekennzeichnet durch**
a). Benetzen einer Fläche (A, B) eines Werkzeuges (3) mit einer Dichtungsmasse (1); und
b). Zusammenbringen der benetzten Fläche (A, B) mit der Kontur (4) des Gehäuseteils (5) in einem einzigen Arbeitsgang unabhängig von der Form der Kontur (4).

2. Verfahren nach Anspruch 1, **gekennzeichnet durch** Benetzen einer ebenen Fläche (A) eines stempelartigen Werkzeuges (3) mit Dichtungsmasse (1).

3. Verfahren nach Anspruch 1, **gekennzeichnet durch** Benetzen einer zylinderförmigen Fläche (B) eines walzenartigen Werkzeuges (3) mit Dichtungsmasse (1).

4. Verfahren nach einem der vorherigen Ansprüche, **gekennzeichnet durch** Bewegen der Kontur (4) im Verhältnis zum Werkzeug (3) beim Aufbringen der Dichtungsmasse (1).

5. Verfahren nach einem der Ansprüche 1 bis 3, **gekennzeichnet durch** Bewegen des Werkzeuges (3) im Verhältnis zur Kontur (4) beim Aufbringen der Dichtungsmasse (1).

6. Verfahren nach einem der vorherigen Ansprüche, **gekennzeichnet durch** Abdichten der Kontur einer Haube zur Abschirmung gegen elektromagnetische Störungen mit einer elektrisch leitfähigen Dichtmasse (1) zur Herstellung einer elektronischen Hochfrequenzschaltung.

7. Verfahren nach Anspruch 2, **gekennzeichnet durch** Verwenden eines stempelartiges Werkzeugs (3) mit einer im Verhältnis zur Stempelfläche wannenartig vertieften Fläche (A) zur Aufnahme der Dichtungsmasse (1) beim Benetzen des Werkzeuges (3).

8. Verfahren nach einem der vorherigen Ansprüche, **gekennzeichnet durch** Verwenden eines Werkzeuges (3), welches eine Fläche (A, B) in einer Größe aufweist, die größer ist als die Umhüllende einer maximal zu benetzenden Kontur (4) eines Gehäuseteils (5).

9. Vorrichtung zur Durchführung des Verfahrens nach einem der vorhergehenden Ansprüche.
